# EUROPEAN PATENT SPECIFICATION

(11) **EP 0 664 486 B1**
(45) Date of publication and mention of the grant of the patent: **03.03.1999**
(21) Application number: 94307901.2
(22) Date of filing: 27.10.1994
(51) Int. Cl.: G03F 7/004

(54) **Waterborne photoresists having non-ionic fluorocarbon surfactants**
Wässrige Emulsionsphotoresiste mit nichtionischen Fluorkohlenwasserstoffenthaltenden oberflächenaktiven Substanzen
Photoreserves en émulsion aqueuse contenant des agents tensioactifs fluorocarbonés non-ioniques

(30) Priority: 25.01.1994 US 186875; 18.02.1994 US 199037; 06.04.1994 US 223615
(43) Date of publication of application: 26.07.1995
(73) Proprietor: Morton International, Inc., Chicago, Illinois 60606-1596 (US)
(72) Inventor: Barr, Robert K., Laguna Niguel, California 92677 (US)
(74) Representative: Bankes, Stephen Charles Digby

(56) References cited:
- DE-A- 3 215 112
- US-A- 5 045 435
- CHEMICAL ABSTRACTS, vol. 111, no. 6, 7 August 1989 Columbus, Ohio, US; abstract no. 48184, T. YAMAMOTO ET AL. 'photosensitive compositions for positive-working lithographic printing plates' page 617; column 2;

## Description

The present invention is directed to photoresists, such as those used for forming printed circuit boards and more particularly to waterborne, liquid applied photoresists and compositions for making them.

Photoimageable compositions useful as resists for forming printed circuits, printing plate, solder masks or the like have been used for some time now. The earliest photoresists were solvent-borne and solvent-developable. The development of aqueous-developable resists represented an advance in reducing solvent emissions in the immediate workplace and in the general environment. The continued emphasis in reducing organic solvent both from the workplace and from the general environment has spurred the search for waterborne photoresists which are formulated and applied as aqueous liquids.

U.S. patent No. 5,045,435 describes a waterborne photoresist composition which is developable in alkaline aqueous solution. The composition comprises a multifunctional monomer, a photoinitiator and a latex of water-insoluble carboxylated acrylic copolymer. To stabilize the composition and to adjust the viscosity, this patent teaches neutralizing the latex polymer to at least 25% with a base, such as ammonia, another amine, or sodium hydroxide.

A liquid, such as a waterborne photoresist liquid will only wet and spread over a surface if the forces of attraction between the liquid and the substrate are greater than the cohesive forces within the liquid. Accordingly, the surface energy of the liquid must be at or below the surface energy of the substrate. Thus, to coat a copper substrate having a surface energy of 3.5 x 10⁻⁴ N/cm (35 dynes/cm), the surface energy of water, which has a surface energy of 7.2 x 10⁻⁴ N/cm (72 dynes/cm), must be dropped. This may be accomplished with the aid of a suitable surfactant. A surfactant is a material with both hydrophilic and hydrophobic properties. Surfactants can be divided into three major chemical classes: hydrocarbons, silicones, and fluorochemicals, these designations referring to the hydrophobic portion of the molecule. The hydrophobe is attached to a hydrophilic group which can be anionic, cationic or nonionic in nature.

Applicants have found neither hydrocarbon surfactants nor silicon surfactants to be particularly suitable surfactants in waterborne photoimageable compositions. Although all types of surfactants are found to sufficiently lower surface energy, it is found that hydrocarbon and silicone surfactants encounter problems respect to dewetting of the copper substrate. Dewetting produces voids which result in an unsuitable coating. Furthermore, if the photoimageable composition is intended as a plating resist, silicone from a silicone-based surfactant can leach into the plating solution creating potential bath failure. Of the major classes of surfactants, hydrocarbon based surfactants are found to be the least effective in reducing the surface tension of the liquid and do not produce defect coatings. Furthermore, hydrocarbon based surfactants contribute to the overall volatile organic components (VOCs) in the coating, which is contrary to the purpose of producing waterborne coatings.

Above-referenced U.S. Patent No. 5,045,435 gives examples wherein fluorocarbon-based surfactants are used in waterborne photoimageable compositions, i.e., those sold under the trademark FLUORAD FC-431 and FC-120. Applicants have found that neither of these performs well. FC-120, which is anionic, wets sufficiently, but produces increased foaming. FC-431 is non-ionic, but is found to be less thai suitable in that it does not eliminate all coating defects, regardless of the concentration level.

It is a general object of the present invention to provide a surfactant for waterborne photoimageable compositions which lowers the surface tension sufficiently for coating on a substrate, such as a copper substrates, does not dewet, and does not cause foaming.

In accordance with the invention, a waterborne photoimageable composition comprises an aqueous composition containing A) between 30 and 80 wt% of a latex binder polymer having acid functionality, e.g., carboxylic acid functionality or sulfonic acid functionality, which provides an acid number of between 50 and 250, B) between 15 and 50 wt% of α,β-ethylenically unsaturated monomer(s), C) between 0.1 and 25 wt% of a photoinitiator or photoinitiator chemical system which generates free radicals, D) between 1 and 40 wt% of a neutralizing base and/or polyether polyurethane associate thickener in amounts sufficient to stabilize the photoimageable composition as an aqueous emulsion and E), between 0.5 and 3.0 wt.% of a surfactant which is a fluoroaliphatic oxyethylene adduct, the weight percentages being based on total weight of components A-E.

Latex binder polymers useful in the photoimageable composition of the present invention are typically prepared by emulsion polymerization of alpha, beta-unsaturated monomers, such as vinyl, acrylate or styrene monomers. Sufficient acid functional monomers are used to provide the acid number of between 50 and 250, preferably at least 100. A typical emulsion polymerization procedure and some examples of suitable emulsions are found in US-A-3,929,743. Suitable emulsions can also be obtained commercially, e.g., Neocryl® CL-340 (40% solids) available from ICI Resins U.S. and Acrysol® I-2074 (46% solids) available from Rohm and Haas.

Suitable acid functional monomers for use in forming the acid functional binder polymer have the formulae: 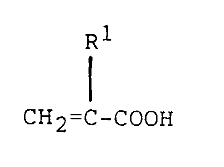 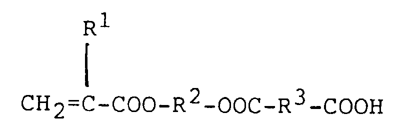 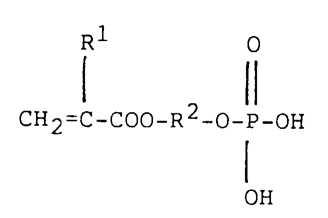 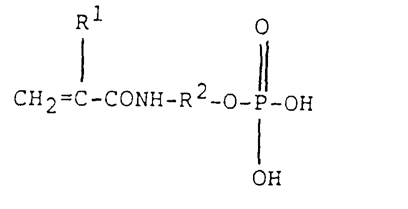 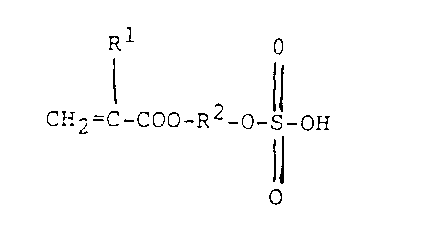 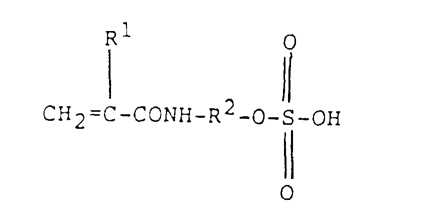 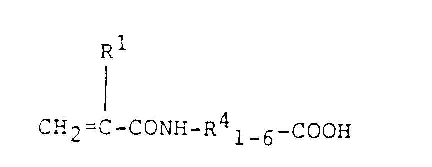 wherein R¹ represents a hydrogen atom or a methyl group, R² represents (CH₂)ₙ wherein n is an integer of 1 to 6, R³ represents an alkylene group having 1 to 6 carbon atoms or a phenylene group, and the R⁴s are the same or different and are selected from CH₂ and CHOH.

Some suitable acid functional monomers are acrylic acid, methacrylic acid, maleic acid, fumaric acid, citraconic acid, 2-acrylamido-2-methylpropanesulfonic acid, 2-hydroxyethyl acryloyl phosphate, 2-hydroxypropyl acryloyl phosphate, 2-hydroxy-alpha-acryloyl phosphate, etc. One or more of such acid functional monomers may be used to form the binder polymer. The acid functional monomers may be copolymerized with non-acid functional monomers, such as esters of acrylic acids, for example, methyl acrylate, methyl methacrylate, hydroxy ethyl acrylate, butyl methacrylate, octyl acrylate, 2-ethoxy ethyl methacrylate, t-butyl acrylate, 1,5-pentanediol diacrylate, N,N-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, and 1,4-benzenediol dimethacrylate; styrene and substituted styrene, such as 2-methyl styrene and vinyl toluene and vinyl esters, such as vinyl acrylate and vinyl methacrylate to provide the desired acid number.

So that the photoimageable composition is contact imageable, i.e., drys to a tack-free state, the glass transition temperature (T_{g}) of the latex binder polymer is preferably at least about 60°C as measured by Differential Scanning Calorimetry (DSC) @ 20°min. The polymers have a weight average molecular weight (Mw) of between about 500 and about 200,000 as measured by gel permeation chromatography (GPS) using a polystyrene standard.

To produce the image, this negative-acting photoimageable composition contains photopolymerizeable monomers, particularly alpha,beta-ethylenically unsaturated monomers, including a substantial portion of multifunctional monomers. Useful monomers include those, listed above, used to form the binder polymers. Particularly suitable monomers include multifunctional acrylic monomers, such as tetraethylene glycol diacrylate (TEGDA), trimethylol propane triacrylate (TMPTA), butanediol dimethacrylate (BDDMA) and pentaerythritol triacrylate (PETA). The monomer fraction may include both water-soluble and water-insoluble monomers; however, the monomer fraction should contain a sufficiently high proportion of water-insoluble (having solubilities in water at 20°C below about 0.3 g/100ml) monomers, e.g., above about 20 mole percent, so that the monomer fraction, as a whole, is insoluble in water.

To initiate polymerization of the monomers upon exposure to actinic radiation, the photoimageable composition contains an appropriate photoinitiator(s) or photoinitiator chemical system. Suitable photoinitiators include benzoin ethers, benzil ketals, acetophenones, benzophenones and related compounds with amines. Preferred initiators are thioxanthones, e.g., 2-isopropyl thioxanthones, particularly in conjunction with an amine.

In accordance with the invention, the waterborne photoimageable composition in accordance with the invention includes a surfactant which is a fluoroaliphatic oxyethylene adduct. Such surfactants have the general formula:

CF₃-(CF₂)ₙ-Y-Xₘ-Z; where n = 0 to 20, Y = SO₂-N(C₁- C₁₀alkyl),

X = CH₂-CH₂-O or CH(CH₃)CH₂-O, m = 0 to 20,

and

Z = CH₂-CH₂-OH or CH(CH₃)-CH₂-OH.

Stabilization of the emulsion, including binder polymer is required. Emulsion stabilization and may be accomplished by at least partial neutralization with a base, as is taught in above- referenced U.S. Patent No. 5,045,435. Preferably, as is taught in U.S. Patent Application No. 08/199,037 of which this application is a continuation-in-part, stabilization of the emulsion and viscosity adjustment are achieved using a polyether polyurethane associate thickener. Polyether polyurethane thickeners are polymers having at least two hydrophobic segments which are the residues of hydrophobic isocyanates, generally isocyanates having isocyanate functionality of 2 or higher, and at least one hydrophilic polyether segment joining the hydrophobic segments by urethane linkages. The block polymers which act as associate thickener may take a variety of forms including ABA, (AB)ₙ, star polymers and the like. The polyether segments are formed from poly(alkylene oxide) segments, formed from monomers such as propylene oxide and ethylene oxide. To be sufficiently hydrophilic, generally it is necessary that at least about 3 mole percent of the poly(alkylene oxide) segment(s) be ethylene oxide residues. The hydrophobic portion of the isocyanate residue is typically an alkyl, cycloalkyl or aromatic moiety. Polyether polyurethane associate thickeners and their function are described, for example by A.J.M. Knoef, and H. Slingerland, "Urethane-Based Polymeric Thickeners for Aqueous Coating Systems" JOCCA, Sept. 1992, pp 335-338; J.H. Bieleman et al. Polymers Paint Colour Journal 1986, V.176(4169) pp. 450-460; and A.J. Whitton and R.E. Van Doren Polymers Paint Colour Journal 1991, V.181(4286) pp. 374-377. Particularly suitable polyether polyurethane associate thickeners and their synthesis are described in U.S. Patent No. 4,079,028 to Emmons et al., the teachings of which are incorporated herein by reference. Suitable polyether polyurethane associate thickeners are also described in US-A-4,426,485 to Hoy et al. and US-A-4,743,698 to Ruffner et al. Examples of suitable commercially available associate thickeners are DSX1514 (Henkel) and QR708 (Rohm and Haas).

By using the polyether polyurethane associate thickener, less neutralization of the binder polymer latex is required. In some cases no neutralization is required. In other cases, it is desirable to neutralize the binder up to about 20% of the equivalent acid functionality of the binder polymer. Typically base will be added to neutralize at least about 2% of the acid functionality of the binder polymer. Neutralization may be done with ammonia; primary, secondary, or tertiary amines; or hydroxides. Preferred neutralizing bases are hydroxy functional tertiary amines. The addition of associate thickener in place of at lease some of the neutralizer allows for a smoother more uniform coating. The improved coating quality minimizes potential circuit board defects caused by thin spots or pin holes in the coating. In addition, when applied by roller coating, the photoimageable composition with associate thickener produces a smoother coating at lower roller compression. Low roller compression results in extended life of the rubber rollers.

Reducing neutralizers improves chemical resistance of the applied and dried photoimageable composition layer. When ammonia or amine use is reduced, odor is reduced. Associate thickeners reduce viscosity drift of the aqueous photoimageable composition. Even under high shear, viscosity tends to remain stable.

In addition to components A-E listed above, minor amounts (generally less than about 10 wt% total based on the weight of A-E) of conventional additives may be used, including; antifoam agents, antioxidants, dyes, adhesion promoters, slip aids, and other surface tension modifiers.

In a preferred method of preparing the waterborne photoimageable composition of the present invention, those components, such as initiators, antioxidants and dyes, most compatible with a hydrophobic phase are admixed with the monomer fraction to produce a monomer base and those components most compatible with an aqueous phase with the latex polymer, such as antifoam, neutralizer surfactant and associate thickener, are admixed to form a polymer mix. The hydrophobic phase and polymer mix are blended to form an hydrophobic phase-in-water emulsion. Subsequently, high boiling solvents, surfactants, including slip aids, surface tension modifiers, and adhesion promoters are added.

The final water-borne composition is generally between 20 and 40 wt. percent solids. In the waterborne composition, the binder comprises between 10 and 30 wt%, monomers from 3 to 20 wt%, initiator from 0.3 to 10 wt%, neutralizing base and/or thickener from 1.5 to 20 wt%, and fluoroaliphatic oxyethylene adduct surfactant between .06 and 2 wt%.

The composition may be coated by any of the coating systems known in the art for coating solvent-borne photoimageable compositions, such as roll coating, dip coating, spray coating or curtain coating.

The compositions of the present invention are applied in a conventional manner, either as liquid compositions directly to a metal clad blank laminate or to a polymeric support sheet to form a dry film. After coating, the composition is dried to remove water and also to remove volatiles, such as ammonia or amine, water, etc., thereby rendering the solution polymer insoluble in acidic or neutral aqueous medium. As the photoimageable composition dries, the system coalesces into a continuous film. Drying is preferably carried out at somewhat elevated temperatures, both to hasten removal of the water, and to drive off the ammonia or volatile amine. Preferably, drying is carried out at a temperature of about 90°C.

In forming a dry film, a water-borne composition is applied to flexible support sheet, e.g., polyethylene terephthalate, and then dried to remove water and volatiles. Subsequently, a protective sheet, e.g., polyethylene, is applied to the photoimageable composition layer, and the dry film is rolled into reels. In drying the photoimageable composition layer, it is found desirable in some cases to leave a residual water content of between about 1 and about 2 wt. % (relative to solids of the photoimageable composition layer). This residual water acts to allow the photoimageable composition layer to conform to surface defects of a substrate, e.g., a copper-clad board, when laminated thereto.

Processing is in a conventional manner. In a typical procedure, a photoimageable composition layer, either formed from a liquid composition or transferred as a layer from a dry film, is applied to a copper surface of a copper-clad board. The photoimageable composition layer is exposed to actinic radiation through appropriate artwork. Exposure to actinic radiation polymerizes the monomer in the light-exposed areas, resulting in a cross-linked structure that is resistant to developer. Next, the composition is developed in dilute alkaline aqueous solution, such as a 1% sodium carbonate solution. The alkali solution causes salt formation with the carboxylic groups of the binder polymers, rendering them soluble and removable. After development, an etchant may be used to remove copper from those areas where the resist was removed, thereby forming a printed circuit. The remaining resist is then removed using an appropriate stripper.

Not only can waterborne primary imaging photoresists be provided in accordance with the invention, but solder mask- forming compositions can be provided as well. By solder mask is meant herein a hard, permanent layer which meets at least the minimal requirements of the abrasion resistance tests as defined in IPC-SM-840B, Table 12, Summary of Criteria for Qualification/Conformance (Institute for Interconnecting Circuits). To become hard and permanent, it is generally necessary that the photoimageable composition be curable after exposure, development and processing of the board, e.g., by thermal and/or UV curing. One way to provide a post-cure is to provide binder polymer having free -OH groups in the backbone that may be cured, for example, by cross-linking with aminoplast resins, such as melamine/formaldehyde resins and urea/formaldehyde resins. Alternatively, the photoimageable composition may contain a compatible epoxy resin and a curative for the epoxy resin. It is found that water-borne photoimageable compositions in accordance with the invention exhibit excellent shelf lives after application to copper substrates and can remain on a copper-clad board upwards of several days.

The invention will now be described in greater detail by way of specific examples.

### Examples 1-4

Water-borne photoimageable compositions were formulated according to Table 1 below. Amounts are in grams. 2.3 grams of neutralizer represents about 15 % neutralization; 4.5 grams of neutralizer represents about 30% neutralization. Performance data is according to Table 2 below. "Monomer base" in Table 1 is per Table 3; all materials being mixed together, filtered and subsequently added to the aqueous portion.

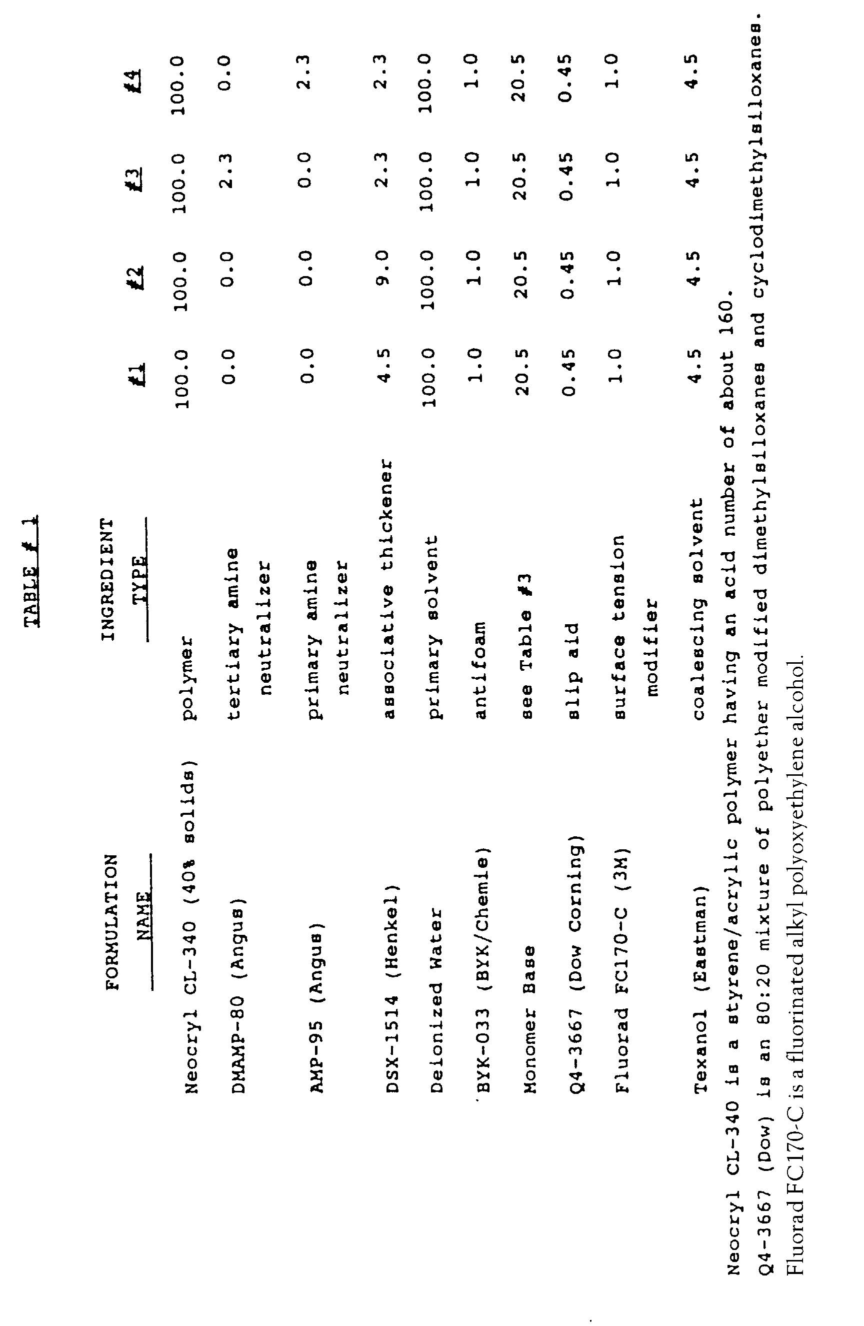

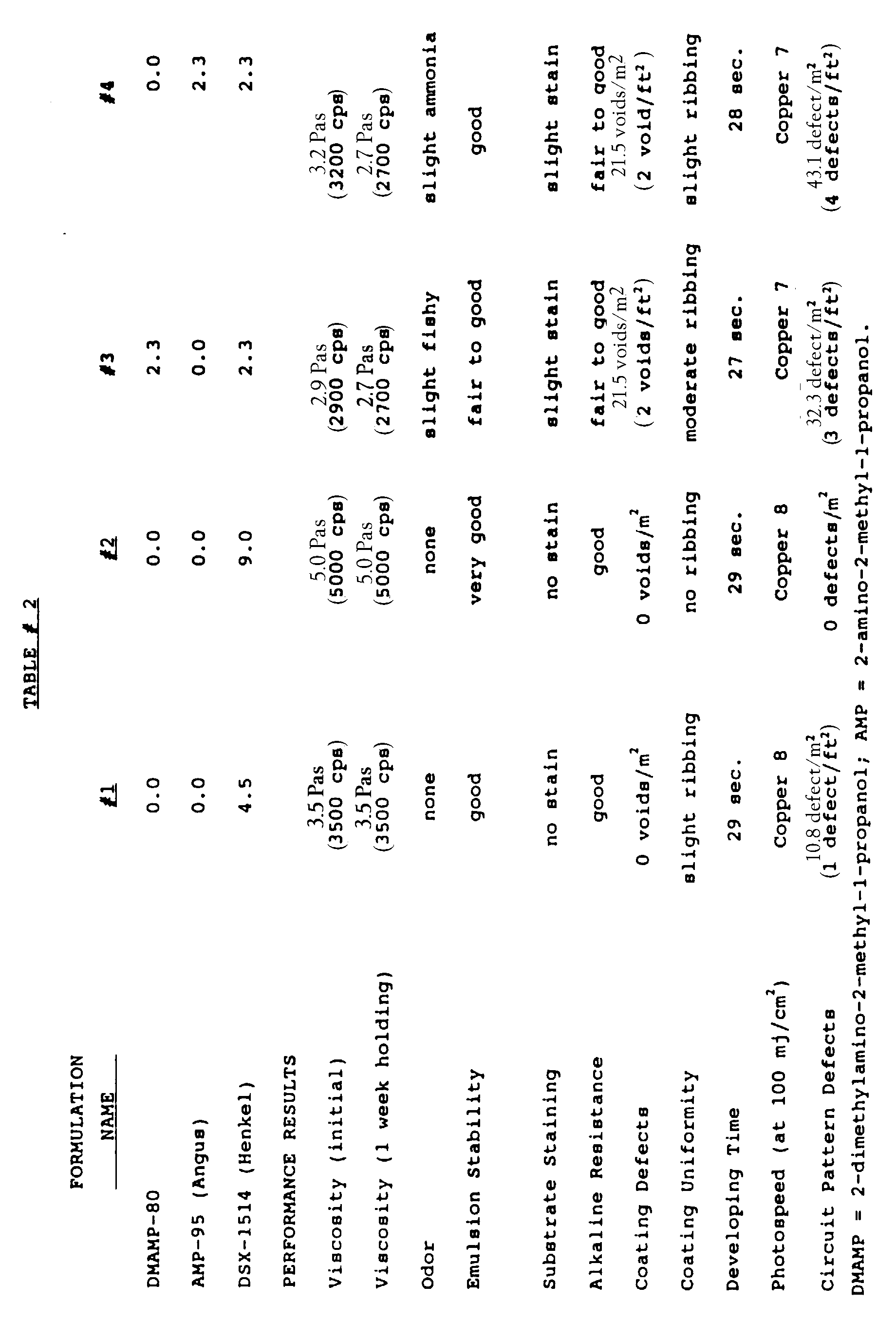

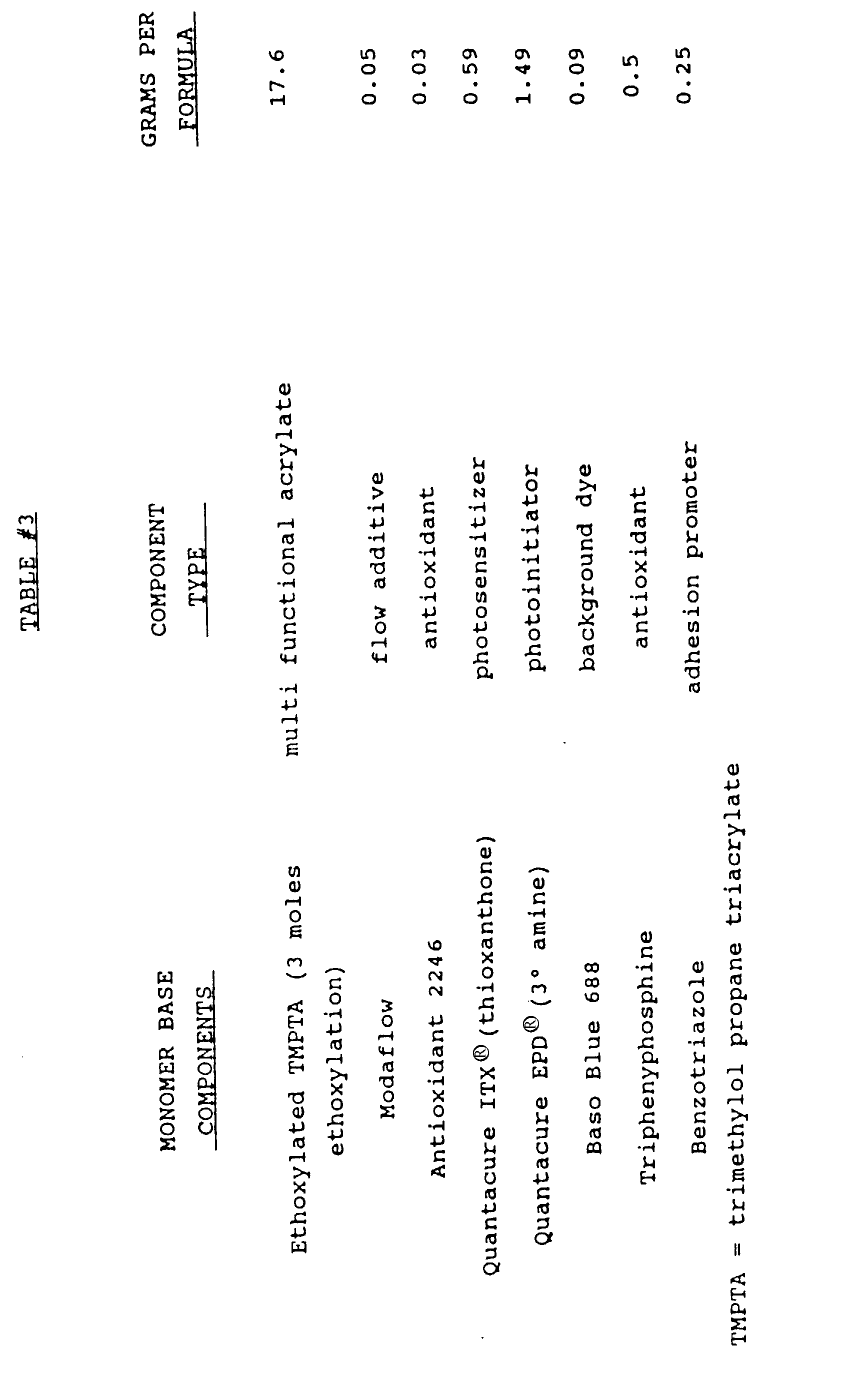

### PROCESSING CONDITIONS

Coating - Burkle (single sided) Roller Coater, 8.7 threads per cm (22 per inch)
Substrate - Copper Clad
Exposure - HMW ORC, model 301 B, diazo artwork
Development - 1% sodium carbonate monohydrate, 29.4°C (85° F), 2x breakpoint
Etching - 3 normal cupric chloride, 60°C (140° F), 1.3 x minimum etch
Stripping - 3% sodium hydroxide, 54.4°C (130° F)

### PERFORMANCE EXPLANATION

Viscosity - measured on a Brookfield viscometer initially and after one week at 21.1°C (70° F)
Odor - the odor was observed after coating and before drying
Emulsion Stability - Stability was rated based on the overall uniformity of the lacquer mixture
Alkaline Resistance - the resistance was measured after alkaline etch at pH 9.2
Coating Defects - the number of coating voids (thin spots) were counted after roller coating
Coating Uniformity - the uniformity was observed immediately after coating
Developing Time - twice the amount of time required to remove the unexposed resist
Photospeed - using a Stouffer 21 step to measure the last remaining step (each step varies by √2)
(Note:a higher step would indicate a higher degree of polymerization)
Circuit Pattern Defects - the total number of circuit shorts and opens were measured
(Note:the artwork pattern contained 0.1 mm (4 mil) lines and 0.1 mm (4 mil) spaces)

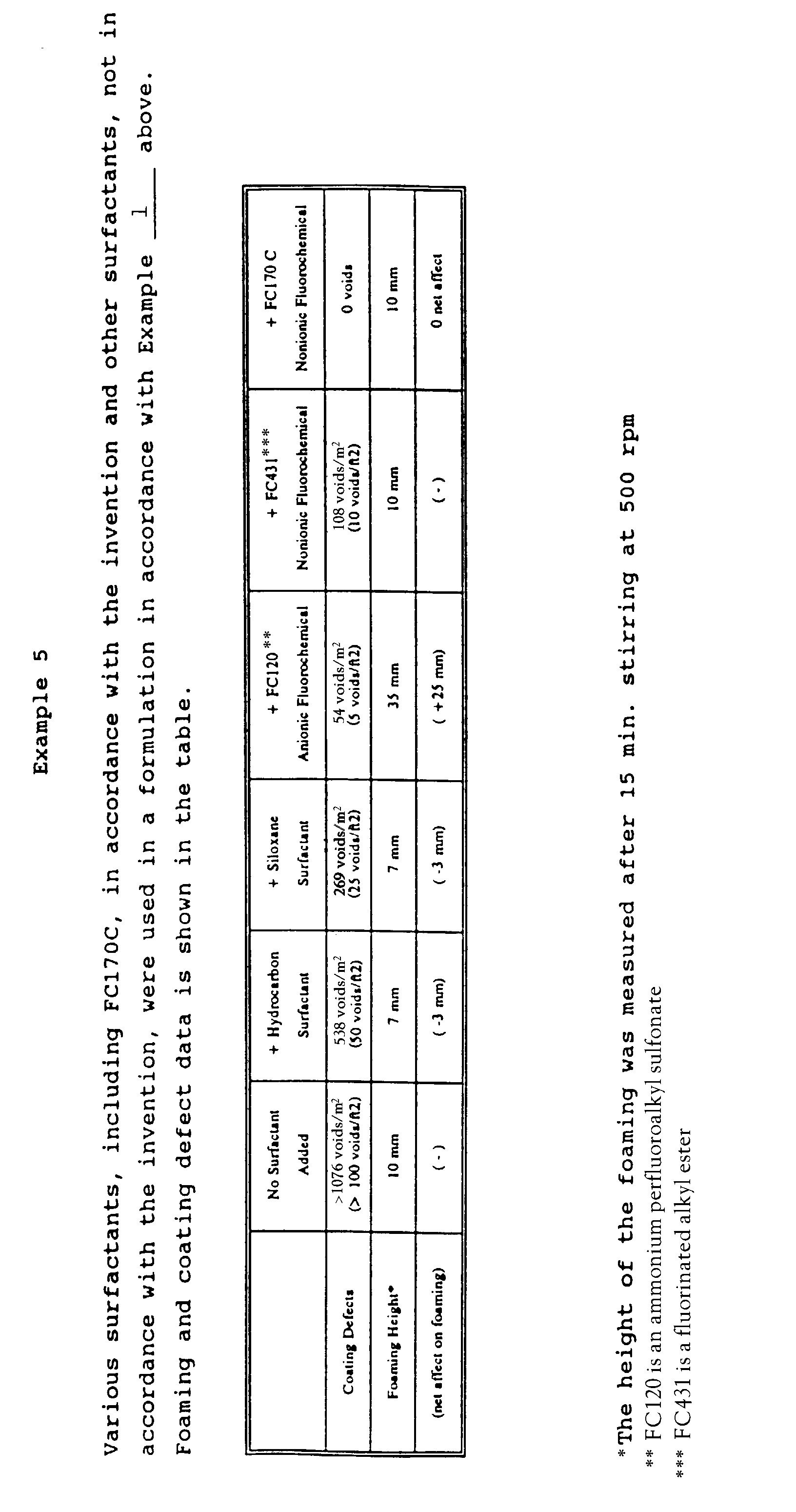

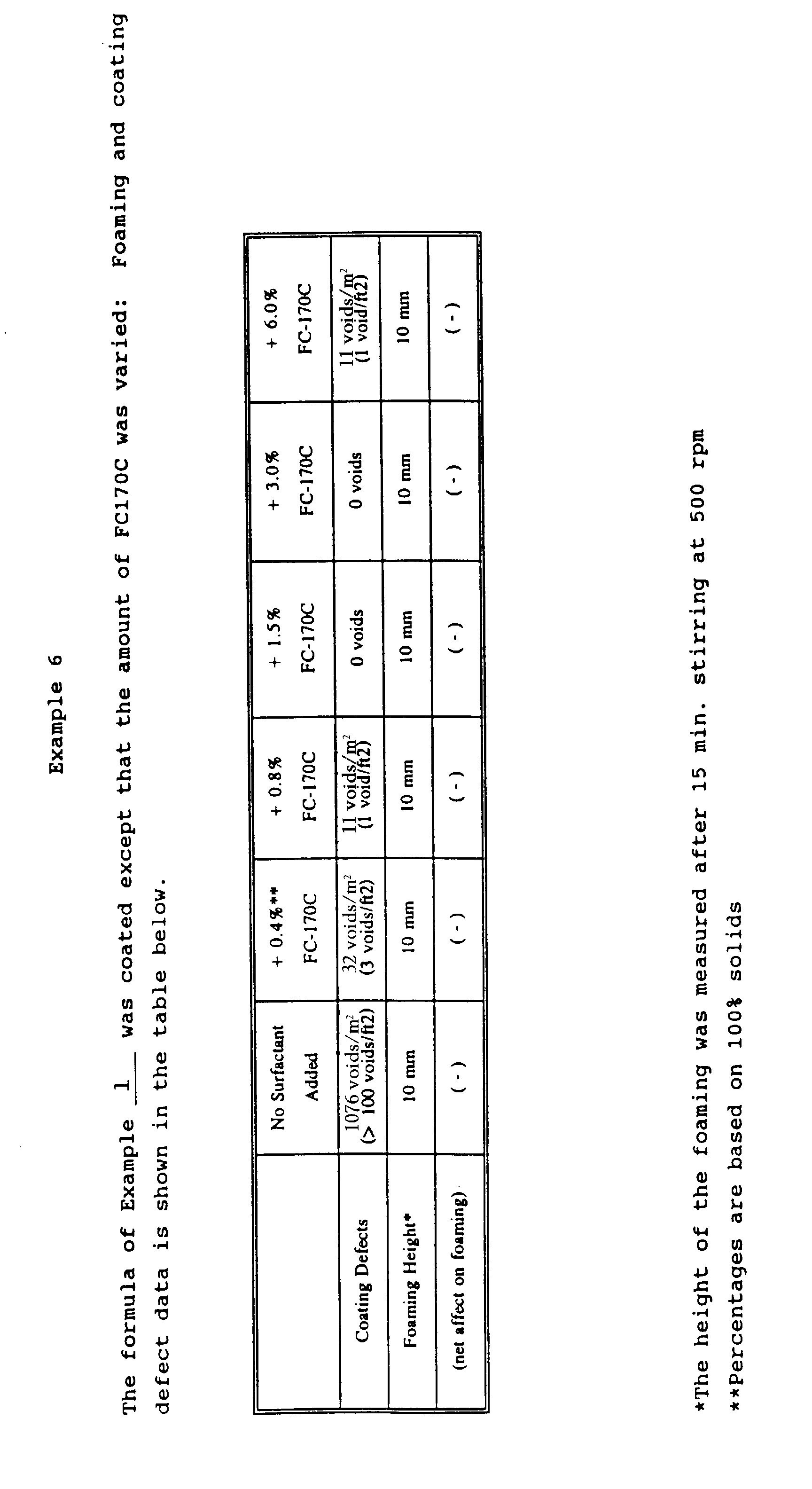

## Claims

1. A waterborne photoimageable composition comprising an aqueous composition containing:
A) between 30 and 80 wt% of a latex binder polymer having carboxylic acid functionality which provides an acid number of between 50 and 250;
B) between 15 and 50 wt% of α,β-ethylenically unsaturated monomers;
C) between 0.1 and 25 wt% of a photoinitiator or photoinitiator chemical system which generates free radicals;
D) between 1 and 40 wt% of a neutralizing base and/or a polyether polyurethane associate thickener in an amount sufficient to stabilize an emulsion of said latex binder polymer; and,
E) between 0.5 and 3.0 wt% of a surfactant which is a fluoroaliphatic oxyethylene adduct having the formula: CF₃-(CF₂)ₙ-Y-Xₘ-Z; where n = 0 to 20, Y = SO₂-N(C₁-C₁₀alkyl), X = CH₂-CH₂-O or CH(CH₃)CH₂-O, m = 0 to 20, and Z = CH₂-CH₂-OH or CH(CH₃)-CH₂-OH, said weight percentages being based on total weight of components A-E.

2. A photoimageable composition according to claim 1 which comprises from 20 to 40 wt.% of solids.

3. A photoimageable composition according to claim 1 or claim 2 which comprises 10 to 30 wt.% of binder (A), 3 to 20 wt.% of monomers (B), 0.3 to 10 wt.% of initiator (C), 1.5 to 20 wt.% of neutralizing base and/or thickener (D) and 0.06 to 2 wt.% of fluorinated oxyethylene adduct surfactant (E), the percentages being based on the total waterborne composition.

4. A dry film comprising a polymeric support sheet and a layer of a photoimageable composition formed by coating the support sheet with a layer of a composition according to any preceding claim and drying to remove water and volatile components.

## Patentansprüche

1. Wäßrige Lichtabbildungszusammensetzung mit einer wäßrigen Zusammensetzung, die
A) zwischen 30 und 80 Gew.-% eines Latexbindemittelpolymers mit Carbonsäurefunktionalität, welche eine Säurezahl zwischen 50 und 250 liefert,
B) zwischen 15 und 50 Gew.-% α,β-ethylenisch ungesättigter Monomere,
C) zwischen 0,1 und 25 Gew.-% eines Photoinitiators oder Photoinitiatorchemikaliensystems, welches freie Radikale erzeugt,
D) zwischen 1 und 40 Gew.-% einer neutralisierenden Base und/oder eines Polyether-Polyurethanverbundverdickungsmittels in einer ausreichenden Menge, um eine Emulsion des Latexbindemittelpolymers zu stabilisieren, und
E) zwischen 0,5 und 3,0 Gew.-% eines oberflächenaktiven Stoffes enthält, welcher ein fluoraliphatisches Oxyethylenaddukt der Formel CF₃-(CF₂)ₙ-Y-Xₘ-Z ist, worin n = 0 bis 20, Y = SO₂-N(C₁-C₁₀-Alkyl), X = CH₂-CH₂-O oder CH(CH₃)CH₂-O, m = 0 bis 20 und Z = CH₂-CH₂-OH oder CH(CH₃)-CH₂-OH, wobei sich die Gewichtsprozente auf das Gesamtgewicht der Komponenten A-E beziehen.

2. Lichtabbildungszusammensetzung nach Anspruch 1, die 20 bis 40 Gew.-% Feststoffe umfaßt.

3. Lichtabbildungszusammensetzung nach Anspruch 1 oder Anspruch 2, die 10 bis 30 Gew.-% Bindemittel (A), 3 bis 20 Gew.-% Monomere (B), 0,3 bis 10 Gew.-% Initiator (C), 1,5 bis 20 Gew.-% neutralisierende Base und/oder Verdickungsmittel (D) und 0,06 bis 2 Gew.-% fluoriertes Oxyethylenaddukt als oberflächenaktivierten Stoff (E) umfaßt, wobei die Prozentsätze sich auf die gesamte wäßrige Zusammensetzung beziehen.

4. Trockenfilm mit einem Polymerträgerbogen und einer Schicht einer Lichtabbildungszusammensetzung, die durch Beschichten des Trägermogens mit einer Schicht der Zusammensetzung nach einem der vorausgehenden Ansprüche und Trocknen unter Entfernung von Wasser und flüchtigen Komponenten gebildet wurde.

## Revendications

1. Composition à base aqueuse pour images photographiques comprenant une composition aqueuse contenant :
A) entre 30 et 80% en poids d'un polymère liant au latex ayant une fonctionnalité acide carboxylique qui procure un indice d'acidité compris entre 50 et 250;
B) entre 15 et 50% en poids de monomères non saturés à l'α,β-éthylène;
C) entre 0,1 et 25% en poids d'un photoamorceur ou système chimique photoamorceur qui produit des radicaux libres;
D) entre 1 et 40% en poids d'une base neutralisante et/ou d'un épaississant associé au polyéther-polyuréthanne en quantité suffisante pour stabiliser une émulsion dudit polymère liant au latex; et
E) entre 0,5 et 3,0% en poids d'un agent tensioactif qui est un adduit d'oxyéthylène fluoroaliphatique ayant la formule :
CF₃-(CF₂)ₙ-Y-Xₘ-Z; où n = 0 à 20, Y = SO₂-N(C₁-C₁₀alkyle),
X = CH₂-CH₂-O ou CH(CH₃)CH₂-O, m = 0 à 20, et Z = CH₂-CH₂-OH ou CH(CH₃)-CH₂-OH, lesdits pourcentages de poids étant basés sur un poids total des composants A-E.

2. Composition pour images photographiques selon la revendication 1, qui comprend 20 à 40% en poids de solides.

3. Composition pour images photographiques selon la revendication 1 ou la revendication 2, qui comprend 10 à 30% en poids de liant (A), 3 à 20% en poids de monomères (B), 0,3 à 10% en poids d'amorceur (C), 1,5 à 20% en poids de base neutralisante et/ou d'épaississant (D) et 0,06 à 2% en poids d'adduit tensioactif à l'oxyéthylène fluoré (E), les pourcentages étant basés sur la composition à base aqueuse totale.

4. Film sec comprenant une feuille de support polymère et une couche de composition pour images photographiques formé par revêtement de la feuille de support avec une couche de composition selon l'une quelconque des revendications précédentes et séchage pour enlever l'eau et les composants volatiles.
